# EUROPEAN PATENT SPECIFICATION

(11) **EP 3 933 862 B1**
(45) Date of publication and mention of the grant of the patent: **19.06.2024**
(21) Application number: 20183432.2
(22) Date of filing: 01.07.2020
(51) Int. Cl.: H01F 27/34, H01F 27/40, H02H 9/04

(54) **TRANSFORMER ARRANGEMENT AND METHOD FOR ELECTRICALLY CONNECTING AND DISCONNECTING A TRANSFORMER**
TRANSFORMATORANORDNUNG UND VERFAHREN ZUR ELEKTRISCHEN VERBINDUNG UND TRENNUNG EINES TRANSFORMATORS
AGENCEMENT DE TRANSFORMATEUR ET PROCÉDÉ POUR CONNECTER ET DÉCONNECTER ÉLECTRIQUEMENT UN TRANSFORMATEUR

(43) Date of publication of application: 05.01.2022
(73) Proprietor: Hitachi Energy Ltd, 8050 Zürich (CH)
(72) Inventor: KLYS, Pawel, 93-008 Lodz (PL); CIESIELSKI, Marcel, 93-185 Lodz (PL); DASZKIEWICZ, Robert, 91-852 Lodz (PL)
(74) Representative: Valea AB

(56) References cited:
- EP-A1- 3 282 458
- DE-A1- 2 058 202
- US-A- 4 621 298

## Description

### TECHNICAL AREA

The present disclosure relates to a transformer arrangement comprising transient voltage protection i.e. an arrangement to protect a transformer from over-voltage transients such as those caused by external (lightning) or internal (switching) events. More in particular it relates to a transformer arrangement having a connectable/disconnectable surge arrester arrangement. It further relates to method of connecting and disconnecting a transformer to or from a surge arrester arrangement.

### BACKGROUND

Different ways of protecting transformers against transient voltages exist, for example using surge arresters and/or resistor-capacitor (RC) protection. Transformers are designed to withstand certain electrical stresses. In order to limit the voltages that a transformer is exposed to, surge arresters may be installed. These limit the voltage between their two connection points. Most commonly, surge arresters are installed phase-to-ground and thus limit the corresponding voltage. They may also be installed phase-to-phase (in case of a delta-connected winding) or phase-to-neutral (in case of a y-connected winding) and will also limit the voltage across the winding. Still however, the internal resonance frequency of the winding may be excited and potentially contribute to significant stress.

EP3282458 discloses a transformer and a transformer arrangement in an insulation fluid in a transformer tank. Surge arresters are used to improve damping of internal resonance in dry transformers by splitting the surge arresters connected across a phase winding in two, with a connection to the midpoint, or to another point of the transformer winding. A factory acceptance test (FAT) of a transformer, e.g. a test of a new transformer before it is shipped to the customer, is carried out after it is installed in the transformer tank with any surge arresters disconnected. Therefore, the surge arresters are arranged outside the transformer tank in order to make the connections between the surge arrester arrangement and the transformer arrangement accessible to be disconnected before the acceptance test and to be re-connected after the test. The connections pass through the wall(s) of the transformer tank via a number of bushings.

The bushings are expensive and the arrangement of the surge arresters on the outside of the transformer tank consumes space, which may not be available on site, where the transformer tank is to be installed. Furthermore, the performance of the bushings may be adversely affected if the bushings are subjected to high ambient temperatures and temperature changes and high and frequent load cycles. The bushings' insulation may deteriorate and they may suffer mechanical damage during their handling and use. Failure of the bushings can result in failure of the whole transformer. Bushings must therefore be monitored and maintained during their use to reduce the risk of unexpected failure and extended system downtime, which can be very costly to network managers.

DE2058202 further discloses a circuit for testing surge arresters. The surge arrester may be connected via a fuse to a transformer.

### SUMMARY OF THE INVENTION

An object of the present invention is therefore to achieve a transformer arrangement having an improved surge arrester arrangement. The surge arrester arrangement is easy to connect and disconnect, less expensive and consumes less space compared to known arrangements.

This object is achieved according to a first aspect of the present disclosure, wherein a transformer arrangement comprises a transformer having a winding and a surge arrester arrangement configured to be connected to the winding of the transformer. The surge arrester arrangement further comprises a surge arrester arranged to be connected across at least a section of the winding of the transformer and a switch. The switch is operable between a closed state and an open state, such that in the closed state, the surge arrester is electrically connected across at least the section of the winding of the transformer, and in the open state, the surge arrester is electrically disconnected from at least the section of the winding of the transformer. The surge arrester arrangement of the transformer arrangement further comprises at least one further surge arrester arranged to be connected across at least one further section of the winding of the transformer. The transformer arrangement additionally comprises at least one further switch. The at least one further switch, is operable between a closed state and an open state, such that in the closed state the at least one further surge arrester is electrically connected across the at least one further section of the winding of the transformer, and in the open state, the at least one further surge arrester is electrically disconnected from the at least one further section of the winding of the transformer

The switch thus allows simple connection and disconnection of the surge arrester to and from the section of the winding across which it is connected.

It is to be understood that the term "section" of a winding is defined as either the full wire length of the winding, or a part of the wire length of the winding of the transformer.

In case the section of the winding is a part of the full wire length of the winding, a further surge arrester and a further switch may be connected across at least one further section of the winding such that the surge arrester arrangement comprises multiple pairs of switches and surge arresters which may be electrically connected and disconnected across the winding of the transformer. In the closed state, the surge arresters are electrically connected in series with each other across the winding of the transformer.

According to another aspect of the present disclosure, the surge arrester arrangement comprises an intermediate connection that is arranged between two surge arresters and configured to connect to the winding of the transformer such that the two surge arresters are connected across respective sections of the winding. Optionally the surge arrester arrangement comprises at least one further intermediate connection, wherein each further intermediate connection connects a further surge arrester across a further section of the winding of the transformer.

Thus, the intermediate connections are arranged between pairs of switches and surge arresters. In the closed state, the surge arresters are electrically connected in series with each other and each surge arrester is further electrically connected in parallel with a respective section of the winding of the transformer.

According to another aspect of the present disclosure, the entire surge arrester arrangement is configured to be electrically connected to the transformer when the switch, or each switch, of the surge arrester arrangement is in the closed state and the entire surge arrester arrangement is configured to be electrically disconnected from the transformer when the switch, or each switch, of the surge arrester arrangement is in the open state.

When the entire surge arrester arrangement is electrically disconnected from the transformer, the transformer may be tested. The switches therefore allow simple connection and disconnection of the entire surge arrester arrangement to and from the winding of the transformer.

According to another aspect of the present disclosure, the transformer arrangement comprises a transformer tank containing insulation fluid, i.e. any suitable fluid for electrically insulating and cooling the transformer, wherein the transformer and the surge arrester arrangement is configured to be at least partly immersed in the insulation fluid in the transformer tank.

The switches and the surge arresters may be arranged with the transformer inside the transformer tank, reducing the number of necessary bushings through the transformer tank wall for connecting the surge arrester arrangement with the transformer. In addition, by accommodating the surge arrester arrangement inside the tank, space is saved on the outside of the tank, making installation of the transformer tank in limited spaces easier. A surge arrester arrangement may be mounted inside the transformer tank in a horizontal position above the transformer core and windings, or in a vertical position alongside the transformer windings.

According to another aspect of the present disclosure, the insulation fluid is an insulation liquid.

The insulation liquid may be an oil, e.g. mineral oil, such as silicone oil, a hydrocarbon oil or an ester-based liquid/oil.

According to another aspect of the present disclosure, the switch, or each switch, is a rotary switch or a tap changer.

The switch needs to have a required voltage withstand capability in the open state, when the transformer is tested. Further, it needs to have a sufficient current-leading capacity to conduct current through the surge arrester(s) in the closed state when the surge arrester arrangement is configured as transient voltage protection for the transformer. The switches may thus be rotary switches or tap changers.

According to another aspect of the present disclosure, the surge arrester is a metal oxide varistor, such as a zinc oxide (ZnO) varistor.

The surge arrester may comprises blocks of ZnO stacked together, which allows installation in insulation fluid, such as insulating oil.

According to another aspect of the present disclosure, the surge arrester comprises a tap configured to connect to the winding via the intermediate connection.

The taps allow simple installation and connection to the transformer. The taps also allow accurate protection of the most stressed parts of the winding.

According to another aspect of the present disclosure, the transformer is a single-phase transformer.

In the case of a single-phase transformer, the surge arrester arrangement is connected or disconnected across the across a winding of the transformer.

According to another aspect of the present disclosure, wherein the transformer comprises phase leg windings of a plurality of phase legs.

In case of a plurality of phase legs, a surge arrester arrangement is arranged at each phase leg. The terms phase leg and phase leg windings may be used interchangeably and denotes a physical winding. However, each phase leg winding (or phase leg) is dedicated to its respective electrical phase of a multi-phase transformer.

According to another aspect of the present disclosure, the phase leg windings () are connected in delta configuration, wye configuration or zigzag (z)-configuration.

The delta configuration, wye configuration or z-configuration are known configurations of phase leg windings of multi-phase transformers. The present disclosure is applicable to any such configuration.

According to another aspect of the present disclosure, the transformer arrangement further comprises an auxiliary surge arrester arrangement electrically connected between the transformer and ground.

The auxiliary surge arrester arrangement may be arranged at least partly inside or at least partly outside the transformer tank. An auxiliary surge arrester arrangement outside the tank does not require switches. However, an auxiliary surge arrester arrangement inside the tank makes installation simpler and it is easier to connect other equipment on site, with the transformer and auxiliary surge arrester arrangement in the transformer tank.

According to a further aspect of the present disclosure, the transformer arrangement comprises a plurality of selectively and individually operable switches. Alternatively, two or more switches may be arranged to operate at the same time. One or more switches may be operated in any suitable manner, such as manually or remotely.

The object is also achieved according to a second aspect of the present disclosure, wherein a method for electrically connecting or disconnecting a transformer to or from a surge arrester arrangement comprising at least one surge arrester and at least one switch, comprises the step of electrically connecting or disconnecting the at least one surge arrester to or from one or more sections of a winding of the transformer by means of the at least one switch. The at least one switch is operable between a closed state and an open state, such that in the closed state, the at least one surge arrester is electrically connected across one or more sections of a winding of the transformer, and in the open state, the at least one surge arrester is electrically disconnected from one or more windings of the transformer, where the surge arrester arrangement further comprises at least one further surge arrester arranged to be connected across at least one further section of the winding of the transformer and at least one further switch. The step of electrically connecting or disconnecting the at least one surge arrester to or from one or more sections of a winding of the transformer by means of the at least one switch further includes connecting or disconnecting the at least one further surge arrester to or from the at least one further sections of a winding of the transformer by means of the at least one further switch.

Thus the method achieves easy connection or disconnection of the entire surge arrester arrangement form the transformer by closing or opening the at least one switch.

### DESCRIPTION OF DRAWINGS

Further objects and advantages of, and features of the invention will be apparent from the following description of one or more embodiments, with reference to the appended drawings, where:
- Fig. 1: shows a single-phase transformer configuration according to an example not falling within the scope of the appended claims.
- Fig. 2-3: show variations of a single-phase transformer configuration installed in a transformer tank according to an example not falling within the scope of the appended claims.
- Fig. 4: shows a sectioned single-phase transformer configuration according to an embodiment of the present disclosure.
- Fig. 5: shows a multi-phase delta transformer configuration according to an embodiment of the present disclosure.
- Fig. 6: shows a multi-phase wye transformer configuration according to an embodiment of the present disclosure.
- Fig. 7: shows a multi-phase wye transformer configuration according to an embodiment of the present disclosure.
- Fig. 8: shows a multi-phase z transformer configuration according to an embodiment of the present disclosure.

It should be noted that the drawings have not necessarily been drawn to scale and that the dimensions of certain features may have been exaggerated for the sake of clarity.

### DETAILED DESCRIPTION

The present invention is described in more detail below, with references to the appended drawings showing examples of embodiments. The invention should not be viewed as limited to the described examples of embodiments. Instead, it is defined by the appended patent claims. Like numbers refer to like elements throughout the description.

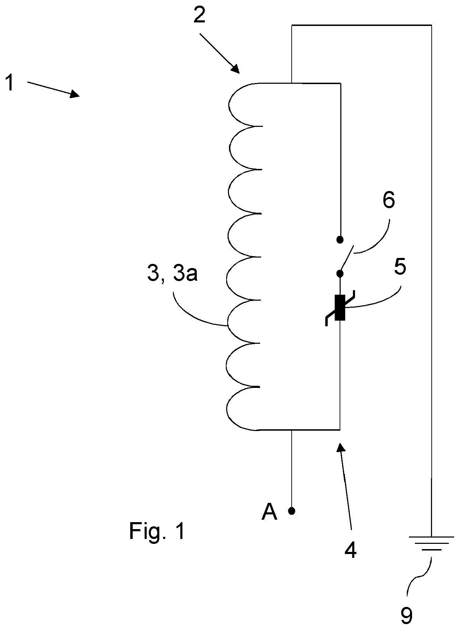

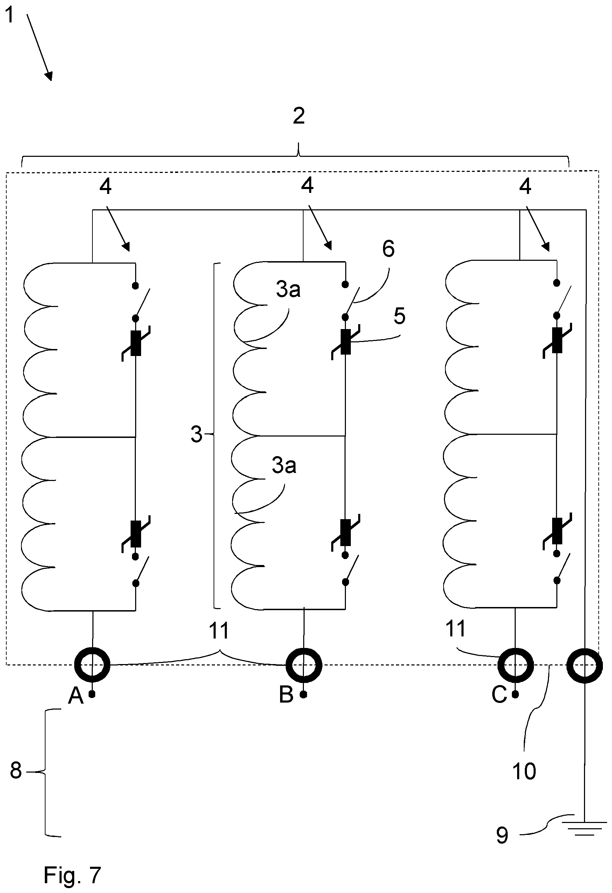

Embodiments of the transformer arrangement comprising the surge arrester arrangement of the present invention will now be discussed with reference to figures 1-7.

**Fig. 1** illustrates a first embodiment of a **transformer arrangement 1.** A **transformer 2** has a **winding 3.** The transformer 2 illustrated in Fig. 1 is configured as a single-phase transformer, being connected to an AC voltage at **terminal A.** A **surge arrester arrangement 4** is configured to be connected to the winding 3 of the transformer 2. The surge arrester arrangement 4 comprises a **surge arrester 5** arranged to be connected across at least a **section 3a** of the winding 3 of the transformer 2. The term "section" of a winding is a section 3a of a wire length of the winding 3 of the transformer 2 and may extend either the full wire length of the winding 3 or a part of the wire length of the winding 3 of the transformer 2. The surge arrester arrangement 4 also comprises a **switch 6.** The switch 6 is operable between a closed state and an open state, such that in the closed state, the surge arrester 5 is electrically connected across at least the section 3a of the winding 3 of the transformer 2, and in the open state, the surge arrester 5 is electrically disconnected from at least the section 3a of the winding 3 of the transformer 2.

The switch needs to have a certain required voltage withstand capability in the open state so that the transformer may be subjected to a factory acceptance test. Further, it needs to have sufficient current-leading capacity to conduct current through the arresters in the closed state when the surge arrester arrangement is configured as a transient voltage protection for the transformer. The switch 6 may thus be a rotary switch or a tap changer.

The surge arrester 5 may be a zinc oxide (ZnO) varistor. The ZnO varistor comprises blocks of ZnO stacked together, which allows installation in insulation fluid, such as insulating oil. The surge arrester/ZnO varistor may further comprise a tap configured to connect to the winding. Such taps allow simple installation and connection to the transformer.

The transformer 2 is further connected to **ground 9.**

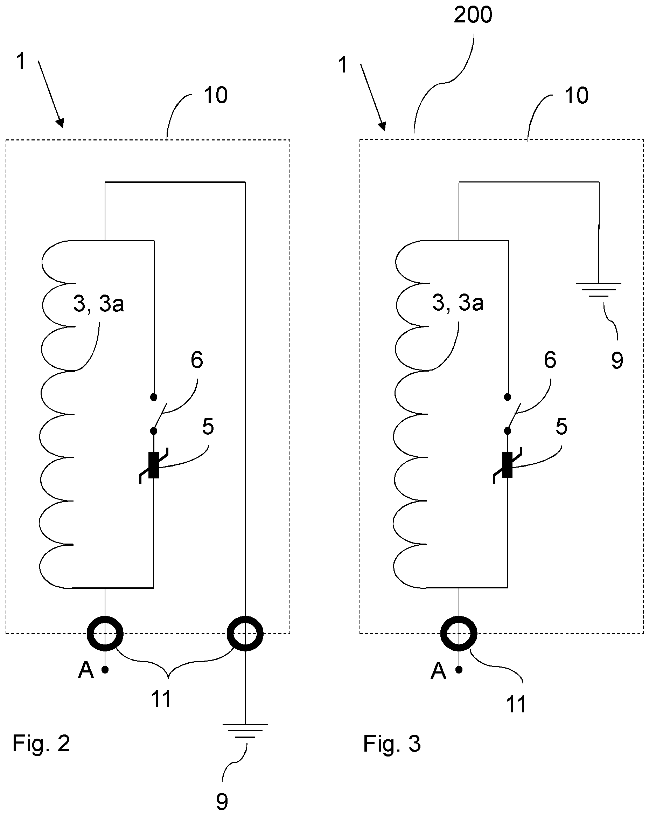

**Fig. 2** and **Fig. 3** show the single-phase transformer 2 of Fig. 1 installed in a **transformer tank 10** containing insulation fluid. The transformer 2 and the surge arrester arrangement 4 are configured to be at least partly immersed in the insulation fluid in the transformer tank 10. The insulation fluid may be a liquid, such as an oil, e.g. a hydrocarbon oil or an ester-based liquid/oil.

The transformer may be externally connected via the terminal A to the AC voltage through a **bushing 11** in the transformer tank wall.

Because of the switched arrangement of the surge arrester 5 to the transformer 2, the switch 6 and the surge arrester 5 may be arranged together with the transformer inside the transformer tank, reducing the number of necessary bushings through the transformer tank wall for connecting the surge arrester arrangement 4 with the transformer 2. In addition, by accommodating the surge arrester arrangement inside the transformer tank 10, space is saved on the outside of the tank, making installation of the transformer tank 10 easier in limited spaces, such as in high-voltage cabinets, etc.

Fig. 2 shows connection of the transformer arrangement 1 to ground 9 outside the transformer tank 10. However, as shown in Fig. 3, it is also possible to connect the transformer arrangement 1 to ground 9 inside the transformer tank 10, eliminating one bushing 11 as compared to the embodiment of Fig. 2.

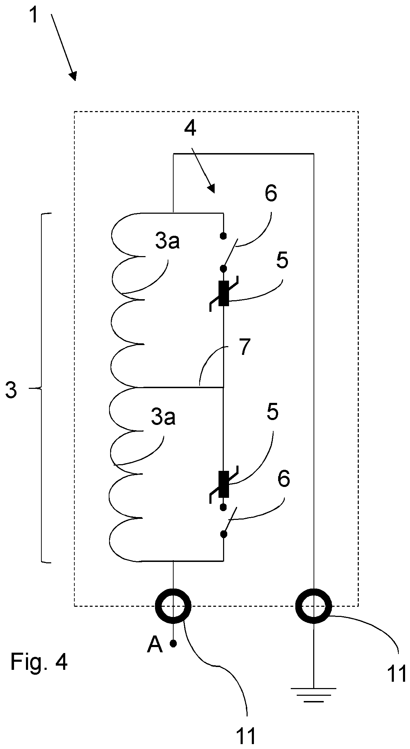

The surge arrester arrangement 4 of the transformer arrangement 1 may further comprise at least one further surge arrester 5, as shown in **Fig. 4**, arranged to be connected across at least one further **section 3a** of the winding 3 of the transformer 2. The winding 3 of the transformer 2 is divided into a number of sections 3a, wherein a surge arrester 5 is connected across each section 3a. The surge arrester arrangement may further comprise at least one further switch 6. The at least one further switch 6, is operable between a closed state and an open state, such that in the closed state the at least one further surge arrester 5 is electrically connected across the at least one further section 3a of the winding 3 of the transformer 2, and in the open state, the at least one further surge arrester 5 is electrically disconnected from the at least one further section 3a of the winding 3 of the transformer 2.

The surge arrester arrangement 4 may comprise an **intermediate connection 7** that is arranged between two surge arresters 5 and configured to connect to the winding 3 of the transformer such that the two surge arresters 5 are connected across respective sections 3a of the winding. Optionally wherein the surge arrester arrangement 4 comprises at least one further intermediate connection 7, each further intermediate connection 7 connects a further surge arrester 5 across a further section 3a of the winding 3 of the transformer 2.

The intermediate connections 7 are arranged between pairs of switches 6 and surge arresters 5. The intermediate connection 7 within the winding 3 may be at the middle of the winding 3, to form two equally large sections 3a, i.e. first and second sections 3a, of the winding 3. Alternatively, the connection within the winding 3 may be such that the first and second winding sections 3a are of different sizes. By means of the intermediate connection 7, a first surge arrester 5 is connected across (to and in parallel with) the first section 3a of the winding 3, and a second surge arrester 5 is connected across (to and in parallel with) the second section 3a of the winding 3. In the embodiment of Fig. 4, the winding 3 is divided into two sections 3a, each with a corresponding surge arrester 5 and switch 6 connected across it. However, a winding 3 may be divided into any number of sections 3a by means of additional intermediate connections 7 (not shown), where each section 3a has a corresponding surge arrester 5 and switch 6 of the series of surge arresters 5 and switches 6 connected across the winding 3. In the closed state, the surge arresters 5 are electrically connected in series with each other and each surge arrester 5 is further electrically connected in parallel with a respective section 3a of the winding 3 of the transformer 2.

The benefit of one or more intermediate connections 7 between at least two surge arresters 5 connected in series with each other in the closed state across (i.e. connected to and in parallel with) the transformer winding 3 and the other connection point(s) within the winding 3, e.g. at the midpoint of the winding 3, is that it limits the internal resonance of the winding 3.

The switches 6 are arranged so that the entire surge arrester arrangement 4 is configured to be electrically connected to the transformer 2 when the switch 6, or each switch 6, of the surge arrester arrangement 4 is in the closed state and the entire surge arrester arrangement 4 is configured to be electrically disconnected from the transformer 2 when the switch 6, or each switch 6, of the surge arrester arrangement (4) is in the open state. When the entire surge arrester arrangement 4 is electrically disconnected from the transformer 2, the transformer 2 may be subjected to the factory acceptance test. The switches allow simple connection and disconnection of the entire surge arrester arrangement 4 to and from the winding 3 of the transformer 2. The switched arrangement is especially beneficial when the transformer arrangement 1 is installed in a transformer tank 10 since the transformer 2 has to be tested without the transient voltage protection after installation in the transformer tank 10.

The transformer 2 may alternatively be a multi-phase transformer, such as a three-phase transformer. The transformer 2 then comprises multiple windings 3 comprising at least one section 3a in the form of phase leg windings of a plurality of phase legs. In terms of the present disclosure regarding the surge arrester arrangement 4 connectable and disconnectable to a transformer 2, each phase leg winding corresponds to a winding 3 of the transformer arrangement 1 described hereinbefore. Accordingly, a phase leg winding is herein equivalent to a winding 3, which comprises at least one section 3a, across which a surge arrester 5 is connectable via a switch 6.

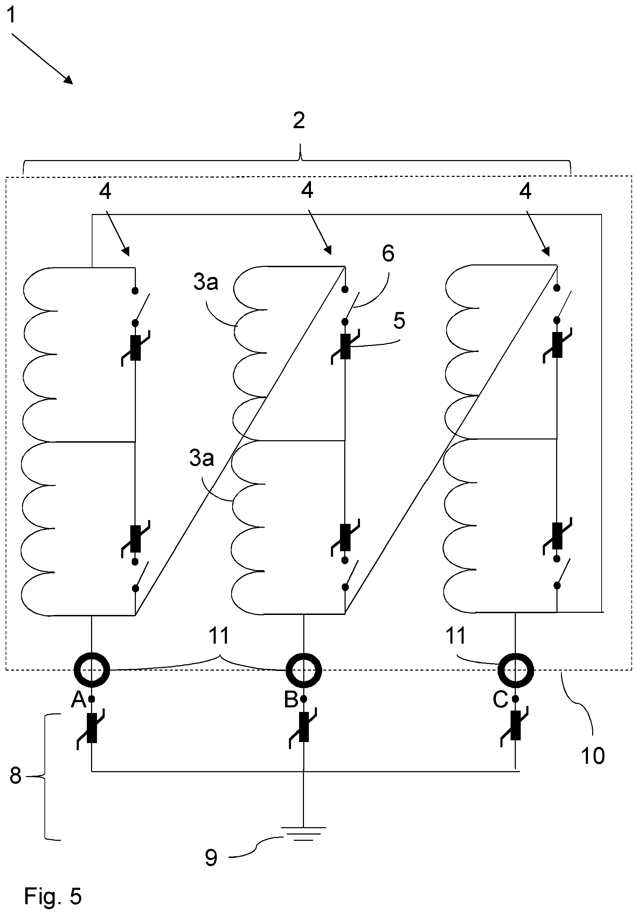

**Fig. 5** shows a three-phase transformer 2. The three phases are connected to a respective phase leg winding via terminals A, Band C through bushings 11 in the wall of the transformer tank 10. The purpose of Fig. 5 is to illustrate the configuration of the surge arrester arrangement 4 applied to a common three-phase transformer. Each winding 3 (phase leg) of the transformer 2 is thus configured with a surge arrester arrangement 4 comprising a surge arrester 5 arranged to be connected across at least a section 3a of the winding 3 (phase leg) of the transformer 2 and a switch 6, and wherein the switch 6 is operable between a closed state and an open state, such that in the closed state, the surge arrester 5 is electrically connected across at least the section 3a of the winding 3 of the transformer 2, and in the open state, the surge arrester 5 is electrically disconnected from at least the section 3a of the winding 3 of the transformer 2.

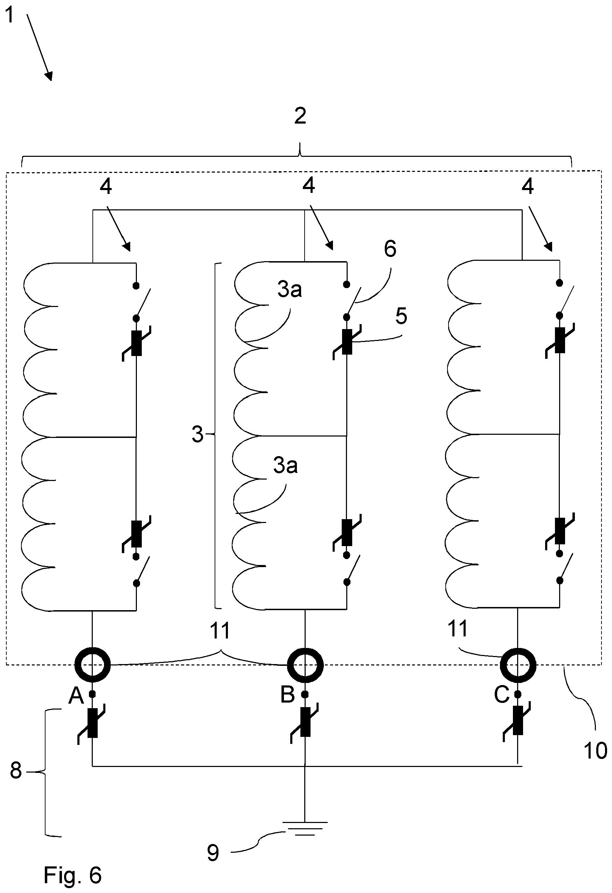

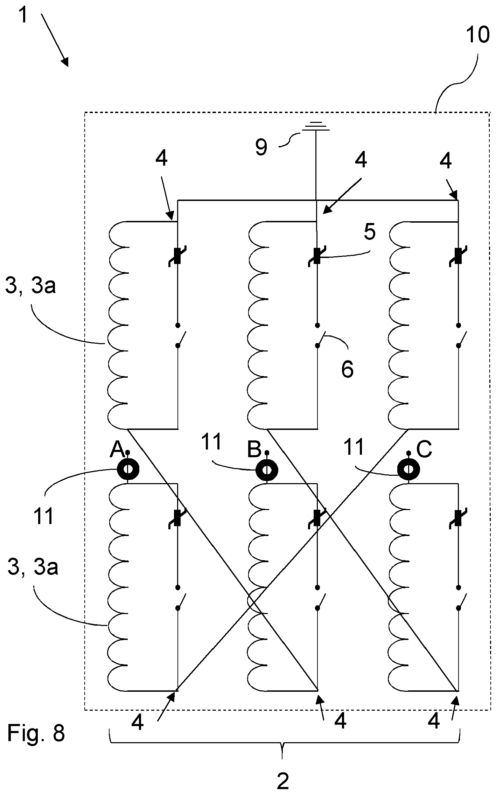

Similarly, **Fig. 6****,** **Fig. 7** and **Fig. 8** show further embodiments of a three-phase transformer 2.

The transformer arrangement 1 of any of the previously described embodiments may comprise an **auxiliary surge arrester arrangement 8** electrically connected between the transformer 2 and ground 9. The auxiliary surge arrester arrangement 8 comprises a surge arrester 5, such as a ZnO varistor. Each phase may comprise one surge arrester connected between the respective phase terminal A, B, C of the transformer 2 and ground 9. The auxiliary surge arrester 8 may alternatively be connected either inside or outside a transformer tank 10.

As compared to prior art, the presently disclosed surge arrester arrangement 4 is easily connectable and disconnectable and allows a reduced number of bushings 11 and a more compact size of the transformer arrangement 1. The single-phase transformer 2 of Figs 1-4 requires one or two bushings 11 if installed in a transformer tank 10, depending on whether the transformer 2 is connected to ground outside or inside the transformer tank 10. The three-phase transformers 2 of Figs 5-7 require three or four bushings 11, depending on whether the transformer 2 is connected to ground outside or inside the transformer tank 10.

Due to the connections of the surge arrester arrangement 4 to the winding 3, a transformer arrangement 1 having a surge arrester arrangement outside the transformer tank, as described in prior art, might require one bushing per connection. In other words, a winding 3 divided into two sections 3a would require three connections to the surge arrester arrangement, i.e. one bushing for a connection at each end of the winding and one bushing for the intermediate connection.

For a prior art three-phase delta-configuration, six bushings may be needed, one for each intermediate connection and one for each terminal wherein a bushing for a connection of one phase leg winding is also for a another connection of an adjacent phase leg winding of the three-phase transformer, as discernible in Fig. 5.

In the case of a prior art three-phase wye configuration, a connection of each phase leg winding is interconnected with the others, forming a neutral point of the transformer. Typically, the neutral point in the wye configuration may be accommodated in the same bushing. Thus, a total of seven bushings may be needed for a three-phase wye configuration; one for the neutral point, three for the terminals, and one second bushing for the intermediate connection of each phase leg winding.

It can thus be seen that the present disclosure achieves a significant advantage over prior art.

## Claims

1. A transformer arrangement (1) comprising:
a transformer (2) having a winding (3);
a surge arrester arrangement (4) configured to be connected to the winding (3) of the transformer (2), and
wherein the surge arrester arrangement (4) comprises a surge arrester (5) arranged to be connected across at least a section (3a) of the winding (3) of the transformer (2) and a switch (6), and wherein the switch (6) is operable between a closed state and an open state, such that in the closed state, the surge arrester (5) is electrically connected across at least the section (3a) of the winding (3) of the transformer (2), and in the open state, the surge arrester (5) is electrically disconnected from at least the section (3a) of the winding (3) of the transformer (2),
**characterized in that** the surge arrester arrangement (4) further comprises:
at least one further surge arrester (5) arranged to be connected across at least one further section (3a) of the winding (3) of the transformer (2);
at least one further switch (6); and
wherein the at least one further switch (6), is operable between a closed state and an open state, such that in the closed state the at least one further surge arrester (5) is electrically connected across the at least one further section (3a) of the winding (3) of the transformer (2), and in the open state, the at least one further surge arrester (5) is electrically disconnected from the at least one further section (3a) of the winding (3) of the transformer (2).

2. The transformer arrangement (1) of claim 1, wherein the surge arrester arrangement (4) comprises an intermediate connection (7) that is arranged between two surge arresters (5) and configured to connect to the winding (3) of the transformer such that the two surge arresters (5) are connected across respective sections (3a) of the winding (3); and optionally wherein the surge arrester arrangement (4) comprises at least one further intermediate connection (7), wherein each further intermediate connection (7) connects a further surge arrester (5) across a further section (3a) of the winding (3) of the transformer (2).

3. The transformer arrangement (1) of any one of the previous claims wherein the entire surge arrester arrangement (4) is configured to be electrically connected to the transformer (2) when each switch (6), of the surge arrester arrangement (4) is in the closed state and the entire surge arrester arrangement (4) is configured to be electrically disconnected from the transformer (2) when each switch (6), of the surge arrester arrangement (4) is in the open state.

4. The transformer arrangement (1) of any one of the previous claims, comprising a transformer tank (10) containing insulation fluid, wherein the transformer (2) and the surge arrester arrangement (4) is configured to be at least partly immersed in the insulation fluid in the transformer tank (10).

5. The transformer arrangement (1) of claim 4, wherein the insulation fluid is an insulation liquid.

6. The transformer arrangement (1) of any one of the previous claims, wherein each switch (6), is a rotary switch or a tap changer.

7. The transformer arrangement (1) of any one of the previous claims, wherein each surge arrester (5) is a zinc oxide (ZnO) varistor.

8. The transformer arrangement (1) of any one of the previous claims, wherein the transformer (2) is a single-phase transformer.

9. The transformer arrangement (1) according to any one of the claims 1-7, wherein the transformer (2) comprises phase leg windings of a plurality of phase legs.

10. The transformer arrangement (1) of claim 9, wherein the phase leg windings are connected in delta configuration.

11. The transformer arrangement (1) of claim 10, wherein the phase leg windings are connected in wye configuration.

12. The transformer arrangement (1) of claim 11, wherein the phase leg windings are connected in zigzag configuration.

13. The transformer arrangement (1) of any one of claims 1-12, wherein the transformer arrangement (1) further comprises an auxiliary surge arrester arrangement (8) electrically connected between the transformer (2) and ground (9).

14. A method for electrically connecting or disconnecting a transformer (2) to or from a surge arrester arrangement (4) comprising at least one surge arrester (5) and at least one switch (6), the method comprising the step of:
electrically connecting or disconnecting the at least one surge arrester (5) to or from one or more sections (3a) of a winding (3) of the transformer (2) by means of the at least one switch (6), wherein the at least one switch (6) is operable between a closed state and an open state, such that in the closed state, the at least one surge arrester (5) is electrically connected across one or more sections (3a) of a winding (3) of the transformer (2), and in the open state, the at least one surge arrester (5) is electrically disconnected from one or more windings (3) of the transformer (2),
**characterized in that** the surge arrester arrangement (4) further comprises:
at least one further surge arrester (5) arranged to be connected across at least one further section (3a) of the winding (3) of the transformer (2);
at least one further switch (6); and
wherein the step of electrically connecting or disconnecting the at least one surge arrester (5) to or from one or more sections (3a) of a winding (3) of the transformer (2) by means of the at least one switch (6) further includes connecting or disconnecting the at least one further surge arrester (5) to or from the at least one further sections (3a) of a winding (3) of the transformer (2) by means of the at least one further switch (6).

## Patentansprüche

1. Transformatoranordnung (1), die Folgendes umfasst:
einen Transformator (2) mit einer Wicklung (3);
eine Überspannungsableiteranordnung (4), die dazu ausgelegt ist, mit der Wicklung (3) des Transformators (2) verbunden zu sein, und
wobei die Überspannungsableiteranordnung (4) einen Überspannungsableiter (5), der dazu angeordnet ist, über mindestens einen Abschnitt (3a) der Wicklung (3) des Transformators (2) verbunden zu sein, und einen Schalter (6) umfasst, und wobei der Schalter (6) zwischen einem geschlossenen Zustand und einem geöffneten Zustand derart betätigbar ist, dass der Überspannungsableiter (5) im geschlossenen Zustand über mindestens den Abschnitt (3a) der Wicklung (3) des Transformators (2) elektrisch verbunden ist und der Überspannungsableiter (5) im geöffneten Zustand von mindestens dem Abschnitt (3a) der Wicklung (3) des Transformators (2) elektrisch getrennt ist,
**dadurch gekennzeichnet, dass** die Überspannungsableiteranordnung (4) ferner Folgendes umfasst:
mindestens einen weiteren Überspannungsableiter (5), der dazu angeordnet ist, über mindestens einen weiteren Abschnitt (3a) der Wicklung (3) des Transformators (2) verbunden zu sein;
mindestens einen weiteren Schalter (6); und
wobei der mindestens eine weitere Schalter (6) zwischen einem geschlossenen Zustand und einem geöffneten Zustand derart betätigbar ist, dass der mindestens eine weitere Überspannungsableiter (5) im geschlossenen Zustand über den mindestens einen weiteren Abschnitt (3a) der Wicklung (3) des Transformators (2) elektrisch verbunden ist und der mindestens eine weitere Überspannungsableiter (5) im geöffneten Zustand von dem mindestens einen weiteren Abschnitt (3a) der Wicklung (3) des Transformators (2) elektrisch getrennt ist.

2. Transformatoranordnung (1) nach Anspruch 1, wobei die Überspannungsableiteranordnung (4) eine Zwischenverbindung (7) umfasst, die zwischen zwei Überspannungsableitern (5) angeordnet und dazu ausgelegt ist, derart mit der Wicklung (3) des Transformators verbunden zu sein, dass die zwei Überspannungsableiter (5) über jeweilige Abschnitte (3a) der Wicklung (3) verbunden sind; und optional wobei die Überspannungsableiteranordnung (4) mindestens eine weitere Zwischenverbindung (7) umfasst, wobei jede weitere Zwischenverbindung (7) einen weiteren Überspannungsableiter (5) über einen weiteren Abschnitt (3a) der Wicklung (3) des Transformators (2) verbindet.

3. Transformatoranordnung (1) nach einem der vorhergehenden Ansprüche, wobei die gesamte Überspannungsableiteranordnung (4) dazu ausgelegt ist, mit dem Transformator (2) elektrisch verbunden zu sein, wenn sich jeder Schalter (6) der Überspannungsableiteranordnung (4) im geschlossenen Zustand befindet, und die gesamte Überspannungsableiteranordnung (4) dazu ausgelegt ist, von dem Transformator (2) elektrisch getrennt zu sein, wenn sich jeder Schalter (6) der Überspannungsableiteranordnung (4) im geöffneten Zustand befindet.

4. Transformatoranordnung (1) nach einem der vorhergehenden Ansprüche, umfassend einen Transformatortank (10), der Isolierfluid enthält, wobei der Transformator (2) und die Überspannungsableiteranordnung (4) dazu ausgelegt sind, zumindest teilweise in das Isolierfluid in dem Transformatortank (10) eingetaucht zu sein.

5. Transformatoranordnung (1) nach Anspruch 4, wobei das Isolierfluid eine Isolierflüssigkeit ist.

6. Transformatoranordnung (1) nach einem der vorhergehenden Ansprüche, wobei jeder Schalter (6) ein Drehschalter oder ein Stufenschalter ist.

7. Transformatoranordnung (1) nach einem der vorhergehenden Ansprüche, wobei jeder Überspannungsableiter (5) ein Zinkoxid(ZnO)-Varistor ist.

8. Transformatoranordnung (1) nach einem der vorhergehenden Ansprüche, wobei der Transformator (2) ein einphasiger Transformator ist.

9. Transformatoranordnung (1) nach einem der Ansprüche 1-7, wobei der Transformator (2) Phasenschenkelwicklungen einer Mehrzahl von Phasenschenkeln umfasst.

10. Transformatoranordnung (1) nach Anspruch 9, wobei die Phasenschenkelwicklungen in einer Dreieckkonfiguration verbunden sind.

11. Transformatoranordnung (1) nach Anspruch 10, wobei die Phasenschenkelwicklungen in einer Sternkonfiguration verbunden sind.

12. Transformatoranordnung (1) nach Anspruch 11, wobei die Phasenschenkelwicklungen in einer Zickzack-Konfiguration verbunden sind.

13. Transformatoranordnung (1) nach einem der Ansprüche 1-12, wobei die Transformatoranordnung (1) ferner eine zusätzliche Überspannungsableiteranordnung (8) umfasst, die zwischen dem Transformator (2) und Masse (9) elektrisch verbunden ist.

14. Verfahren zum elektrischen Verbinden oder Trennen eines Transformators (2) mit bzw. von einer Überspannungsableiteranordnung (4), die mindestens einen Überspannungsableiter (5) und mindestens einen Schalter (6) umfasst, wobei das Verfahren den folgenden Schritt umfasst:
elektrisches Verbinden oder Trennen des mindestens einen Überspannungsableiters (5) mit bzw. von einem oder mehreren Abschnitten (3a) einer Wicklung (3) des Transformators (2) mittels des mindestens einen Schalters (6), wobei der mindestens eine Schalter (6) zwischen einem geschlossenen Zustand und einem geöffneten Zustand derart betätigbar ist, dass der mindestens eine Überspannungsableiter (5) im geschlossenen Zustand über einen oder mehrere Abschnitte (3a) einer Wicklung (3) des Transformators (2) elektrisch verbunden ist und der mindestens eine Überspannungsableiter (5) im geöffneten Zustand von einer oder mehreren Wicklungen (3) des Transformators (2) elektrisch getrennt ist,
**dadurch gekennzeichnet, dass** die Überspannungsableiteranordnung (4) ferner Folgendes umfasst:
mindestens einen weiteren Überspannungsableiter (5), der dazu angeordnet ist, über mindestens einen weiteren Abschnitt (3a) der Wicklung (3) des Transformators (2) verbunden zu sein;
mindestens einen weiteren Schalter (6); und
wobei der Schritt zum elektrischen Verbinden oder Trennen des mindestens einen Überspannungsableiters (5) mit bzw. von einem oder mehreren Abschnitten (3a) einer Wicklung (3) des Transformators (2) mittels des mindestens einen Schalters (6) ferner Verbinden oder Trennen des mindestens einen weiteren Überspannungsableiters (5) mit bzw. von den mindestens einen weiteren Abschnitten (3a) einer Wicklung (3) des Transformators (2) mittels des mindestens einen weiteren Schalters (6) umfasst.

## Revendications

1. Agencement de transformateur (1), comprenant :
un transformateur (2) comportant un enroulement (3) ;
un agencement de parafoudre (4) configuré pour être connecté à l'enroulement (3) du transformateur (2), et
l'agencement de parafoudre (4) comprenant un parafoudre (5) conçu pour être connecté à au moins une section (3a) de l'enroulement (3) du transformateur (2) et un interrupteur (6), et l'interrupteur (6) pouvant être actionné entre un état fermé et un état ouvert, de telle sorte qu'à l'état fermé le parafoudre (5) soit connecté électriquement à l'au moins une section (3a) de l'enroulement (3) du transformateur (2), et qu'à l'état ouvert le parafoudre (5) soit déconnecté électriquement de l'au moins une section (3a) de l'enroulement (3) du transformateur (2),
**caractérisé en ce que** l'agencement de parafoudre (4) comprend en outre :
au moins un autre parafoudre (5) conçu pour être connecté à au moins une autre section (3a) de l'enroulement (3) du transformateur (2) ;
au moins un autre interrupteur (6) ; et
l'au moins un autre interrupteur (6) pouvant être actionné entre un état fermé et un état ouvert, de telle sorte qu'à l'état fermé l'au moins un autre parafoudre (5) soit connecté électriquement à l'au moins une autre section (3a) de l'enroulement (3) du transformateur (2), et qu'à l'état ouvert l'au moins un autre parafoudre (5) soit déconnecté électriquement de l'au moins une autre section (3a) de l'enroulement (3) du transformateur (2).

2. Agencement de transformateur (1) selon la revendication 1, dans lequel l'agencement de parafoudre (4) comprend une connexion intermédiaire (7) qui est agencée entre deux parafoudres (5) et configurée pour se connecter à l'enroulement (3) du transformateur de telle sorte que les deux parafoudres (5) soient connectés à des sections (3a) respectives de l'enroulement (3) ; et éventuellement, dans lequel l'agencement de parafoudre (4) comprend au moins une autre connexion intermédiaire (7), chaque autre connexion intermédiaire (7) connectant un autre parafoudre (5) à une autre section (3a) de l'enroulement (3) du transformateur (2).

3. Agencement de transformateur (1) selon l'une quelconque des revendications précédentes, dans lequel l'ensemble de l'agencement de parafoudre (4) est configuré pour être connecté électriquement au transformateur (2) lorsque chaque interrupteur (6) de l'agencement de parafoudre (4) est à l'état fermé et l'ensemble de l'agencement de parafoudre (4) est configuré pour être déconnecté électriquement du transformateur (2) lorsque chaque interrupteur (6) de l'agencement de parafoudre (4) est à l'état ouvert.

4. Agencement de transformateur (1) selon l'une quelconque des revendications précédentes, comprenant un réservoir de transformateur (10) contenant un fluide d'isolation, le transformateur (2) et l'agencement de parafoudre (4) étant configurés pour être au moins en partie immergés dans le fluide d'isolation dans le réservoir de transformateur (10).

5. Agencement de transformateur (1) selon la revendication 4, dans lequel le fluide d'isolation est un liquide d'isolation.

6. Agencement de transformateur (1) selon l'une quelconque des revendications précédentes, dans lequel chaque interrupteur (6) est un interrupteur rotatif ou un changeur de prise.

7. Agencement de transformateur (1) selon l'une quelconque des revendications précédentes, dans lequel chaque parafoudre (5) est une varistance à l'oxyde de zinc (ZnO).

8. Agencement de transformateur (1) selon l'une quelconque des revendications précédentes, dans lequel le transformateur (2) est un transformateur monophasé.

9. Agencement de transformateur (1) selon l'une quelconque des revendications 1 à 7, dans lequel le transformateur (2) comprend des enroulements de branche de phase d'une pluralité de branches de phase.

10. Agencement de transformateur (1) selon la revendication 9, dans lequel les enroulements de branche de phase sont connectés en configuration triangle.

11. Agencement de transformateur (1) selon la revendication 10, dans lequel les enroulements de branche de phase sont connectés en configuration étoile.

12. Agencement de transformateur (1) selon la revendication 11, dans lequel les enroulements de branche de phase sont connectés en configuration zigzag.

13. Agencement de transformateur (1) selon l'une quelconque des revendications 1 à 12, l'agencement de transformateur (1) comprenant en outre un agencement de parafoudre auxiliaire (8) connecté électriquement entre le transformateur (2) et la masse (9).

14. Procédé pour connecter électriquement un transformateur (2) à un agencement de parafoudre (4) ou pour l'en déconnecter, l'agencement de parafoudre (4) comprenant au moins un parafoudre (5) et au moins un interrupteur (6), le procédé comprenant l'étape consistant à :
connecter électriquement l'au moins un parafoudre (5) à une ou plusieurs sections (3a) d'un enroulement (3) du transformateur (2) au moyen d'au moins un interrupteur (6) ou l'en déconnecter, l'au moins un interrupteur (6) pouvant être actionné entre un état fermé et un état ouvert, de telle sorte qu'à l'état fermé l'au moins un parafoudre (5) soit connecté électriquement à une ou plusieurs sections (3a) d'un enroulement (3) du transformateur (2), et qu'à l'état ouvert l'au moins un parafoudre (5) soit déconnecté électriquement d'un ou plusieurs enroulements (3) du transformateur (2),
**caractérisé en ce que** l'agencement de parafoudre (4) comprend en outre :
au moins un autre parafoudre (5) conçu pour être connecté à au moins une autre section (3a) de l'enroulement (3) du transformateur (2) ;
au moins un autre interrupteur (6) ; et
l'étape consistant à connecter électriquement l'au moins un parafoudre (5) à une ou plusieurs sections (3a) d'un enroulement (3) du transformateur (2) au moyen d'au moins un commutateur (6) ou à l'en déconnecter comprend en outre l'étape consistant à connecter l'au moins un autre parafoudre (5) à l'au moins une autre section (3a) d'un enroulement (3) du transformateur (2) au moyen d'au moins un autre interrupteur (6) ou à l'en déconnecter.
